# EUROPEAN PATENT APPLICATION

(11) **EP 4 546 955 A1**
(43) Date of publication of application: **30.04.2025**
(21) Application number: 24188653.0
(22) Date of filing: 15.07.2024
(51) Int. Cl.: H05K 3/28

(54) **MOTHERBOARD ASSEMBLY, MOTHERBOARD MODULE AND ASSEMBLING METHOD THEREOF**

(30) Priority: 26.10.2023 US 202363545789 P
(71) Applicant: Getac Technology Corporation, New Taipei City 221009 (TW)
(72) Inventor: YANG, Jui-Lin, Taipei City (TW)
(74) Representative: dompatent von Kreisler Selting Werner - Partnerschaft von Patent- und Rechtsanwälten mbB

(57) **Abstract**

A motherboard module (1, 1a) includes a motherboard assembly (10) and an insertion piece (20). The motherboard assembly (10) includes a motherboard (11), an electrical connector (12, 12a), a first sealing component (13, 13a) and a second sealing component (14). The electrical connector (12, 12a) is disposed on the motherboard (11). The first sealing component (13, 13a) is disposed on the motherboard (11) and located around a periphery of the electrical connector (12, 12a). The second sealing component (14) is disposed on the first sealing component (13, 13a). The insertion piece (20) has an insertion portion (21). The insertion portion (21) is inserted into the electrical connector (12, 12a), and the second sealing component (14) and the first sealing component (13, 13a) cover the electrical connector (12, 12a) and the insertion portion (21) of the insertion piece (20) together.

## Description

### TECHNICAL FIELD

The invention relates to a motherboard assembly, a motherboard module and an assembling method thereof.

### BACKGROUND

Currently, an electronic module in an electronic device (e.g., a desktop computer, a notebook computer and a server) is connected to a motherboard through a flexible cable. In order to prevent moisture from causing corrosion at a place where the flexible flat cable is connected to the motherboard and affecting signal transmission, a common solution is to apply a waterproof glue at the place where the flexible flat cable is connected to the motherboard. However, it is difficult to apply the waterproof glue at such place, and the waterproof glue may cause the maintenance of electronic device to be inconvenient. Therefore, how to address the aforementioned issues is one of the crucial topics in this field.

### SUMMARY

The invention provides a motherboard assembly, a motherboard module and an assembling method thereof which can ensure the waterproof effect to the place where the flexible flat cable is connected to the motherboard while enabling the maintenance of electronic device to be convenient.

One embodiment of the invention provides a motherboard module. The motherboard module includes a motherboard assembly and an insertion piece. The motherboard assembly includes a motherboard, an electrical connector, a first sealing component and a second sealing component. The electrical connector is disposed on the motherboard. The first sealing component is disposed on the motherboard and located around a periphery of the electrical connector. The second sealing component is disposed on the first sealing component. The insertion piece has an insertion portion. The insertion portion is inserted into the electrical connector, and the second sealing component and the first sealing component cover the electrical connector and the insertion portion of the insertion piece together.

Another embodiment of the invention provides a motherboard assembly. The motherboard assembly is configured for insertion of an insertion piece. The motherboard assembly includes a motherboard, an electrical connector, a first sealing component and a second sealing component. The electrical connector is disposed on the motherboard and configured for insertion of an insertion portion of the insertion piece. The first sealing component is disposed on the motherboard and located around a periphery of the electrical connector. The second sealing component is disposed on the first sealing component. The second sealing component and the first sealing component are configured to cover the electrical connector and the insertion portion of the insertion piece together.

Still another embodiment of the invention provides an assembling method of a motherboard module. The assembling method includes assembling a first sealing component on a motherboard to surround a periphery of an electrical connector disposed on the motherboard, inserting an insertion portion of an insertion piece into the electrical connector and assembling a second sealing component on the first sealing component to allow the second sealing component and the first sealing component cover the electrical connector and the insertion portion of the insertion piece together.

According to the motherboard modules and the motherboard assemblies as discussed in the above embodiments, the first sealing component is disposed on the motherboard and located around the periphery of the electrical connector, and the second sealing component is disposed on the first sealing component for allowing the second sealing component and the first sealing component to cover the electrical connector on the motherboard and the insertion portion of the insertion piece, which not only provides a waterproof effect to a place where the insertion portion of the insertion piece is inserted into the electrical connector, but also facilitates the removal of the insertion portion of the insertion piece from the electrical connector on the motherboard during maintenance.

### BRIEF DESCRIPTION OF THE DRAWINGS

The present invention will become better understood from the detailed description given herein below and the accompanying drawings which are given by way of illustration only and thus are not intending to limit the present invention and wherein:
FIG. 1 is a partial perspective view of a motherboard module according to a first embodiment of the invention;
FIG. 2 is an exploded view of the motherboard module in FIG. 1;
FIGS. 3 and 4 show an assembling process of the motherboard module in FIG. 1;
FIG. 5 is a partial perspective view of a motherboard module according to a second embodiment of the invention;
FIG. 6 is an exploded view of the motherboard module in FIG. 5;
FIG. 7 is a side view of the motherboard module in FIG. 5; and
FIGS. 8 to 10 show an assembling process of the motherboard module in FIG. 5.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In addition, the terms used in the present invention, such as technical and scientific terms, have its own meanings and can be comprehended by those skilled in the art, unless the terms are additionally defined in the present invention. That is, the terms used in the following paragraphs should be read on the meaning commonly used in the related fields and will not be overly explained, unless the terms have a specific meaning in the present invention.

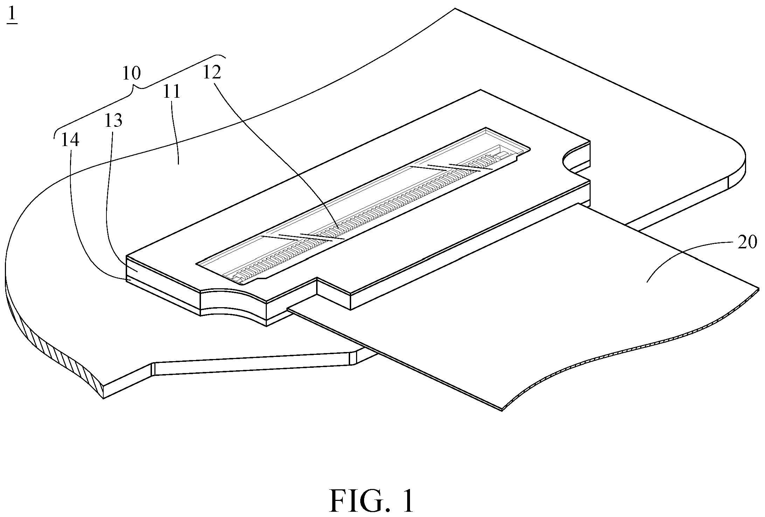

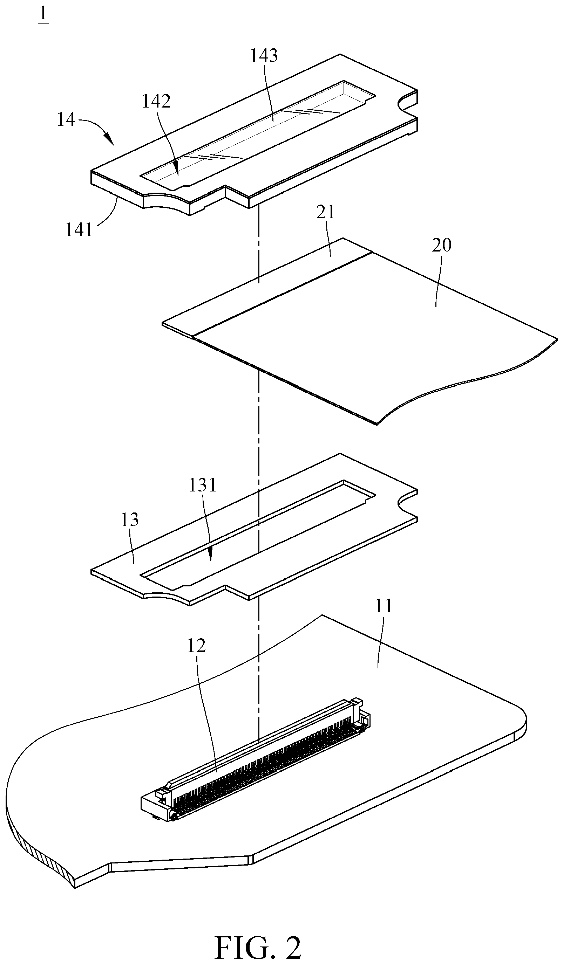

Referring to FIGS. 1 and 2, FIG. 1 is a partial perspective view of a motherboard module 1 according to a first embodiment of the invention, and FIG. 2 is an exploded view of the motherboard module 1 in FIG. 1.

In this embodiment, the motherboard module 1 is applied to an electronic device, such as a notebook computer or a tablet computer. The motherboard module 1 includes a motherboard assembly 10 and an insertion piece 20. The motherboard assembly 10 includes a motherboard 11, an electrical connector 12, a first sealing component 13 and a second sealing component 14.

The electrical connector 12, for example, mates with a flexible flat cable or a flexible printed circuit. The electrical connector 12 is disposed on the motherboard 11.

The first sealing component 13 is, for example but not limited to, a foam. The first sealing component 13 is in a ring shape and surrounds an accommodation hole 131. Specifically, the accommodation hole 131 is opened in the first sealing component 13. The first sealing component 13 is fixed on the motherboard 11 via, for example, adhering manner, and the electrical connector 12 is located in the accommodation hole 131, such that the first sealing component 13 is located around a periphery of the electrical connector 12.

The second sealing component 14 is, for example, made of a composite material containing a foam and a light-permeable sheet, and the second sealing component 14 and the first sealing component 13 have a same shape. The second sealing component 14 is disposed on the first sealing component 13, and the light permeable sheet thereof corresponds to the electrical connector 12. Specifically, the second sealing component 14 includes an annular portion 141, a hollow portion 142 and a light permeable portion 143. The annular portion 141 is, for example, a part in the second sealing component 14 as the foam, and the annular portion 141 is fixed on the first sealing component 13 via, for example, adhering manner. The annular portion 141 surrounds the hollow portion 142, and the hollow portion 142 corresponds to the electrical connector 12. The light permeable portion 143 is, for example, a part in the second sealing component 14 as the light permeable sheet, and the light permeable sheet is, for example, made of Mylar. The light permeable portion 143 is disposed on the annular portion 141 and seals the hollow portion 142.

The insertion piece 20 is, for example, a flexible flat cable or a flexible printed circuit. The insertion piece 20 has an insertion portion 21 located at one end of the insertion piece 20, and another end of the insertion piece 20 is connected to another electronic component of the electronic device. The insertion portion 21 of the insertion piece 20 is inserted into the electrical connector 12, and the second sealing component 14 and the first sealing component 13 cover the electrical connector 12 and the insertion portion 21 of the insertion piece 20 together.

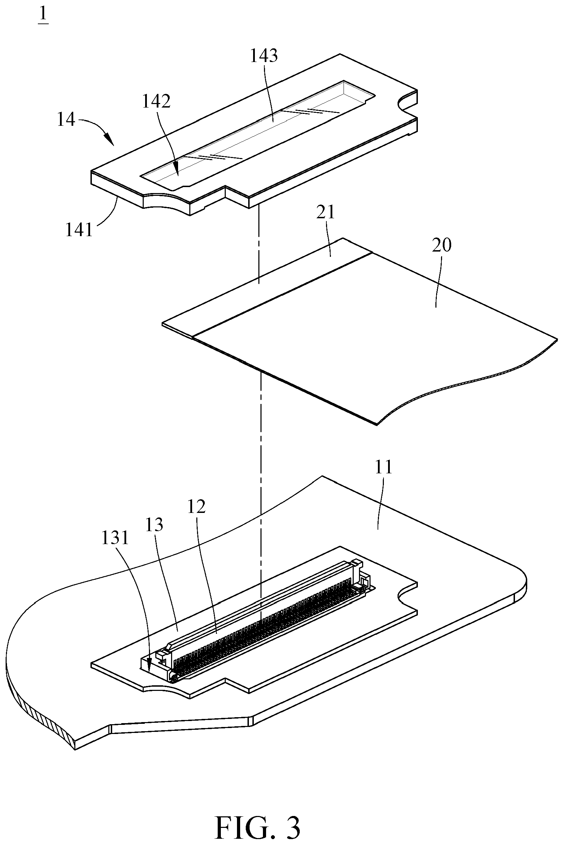

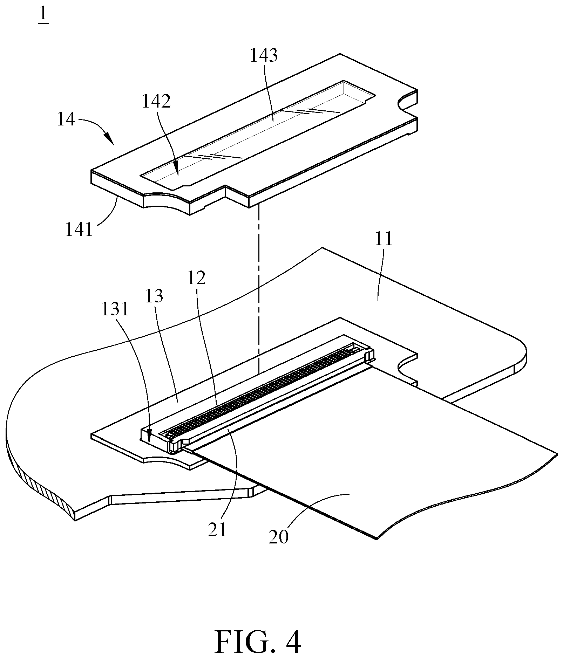

Then, the following descriptions will introduce an assembling process of the motherboard module 1. Referring to FIGS. 3 and 4, FIGS. 3 and 4 show an assembling process of the motherboard module 1 in FIG. 1. Firstly, as shown in FIG. 3, the first sealing component 13 is adhered on the motherboard 11, such that the first sealing component 13 surrounds the periphery of the electrical connector 12 on the motherboard 11. Then, as shown in FIG. 4, the insertion portion 21 of the insertion piece 20 is inserted into the electrical connector 12 of the motherboard 11. Then, the annular portion 141 of the second sealing component 14 is adhered on the first sealing component 13, such that the first sealing component 13 and the second sealing component 14 cover the electrical connector 12 and the insertion portion 21 of the insertion piece 20 together (e.g., shown in FIG. 1). As a result, the assembly of the motherboard module 1 is finished. On the other hand, during the maintenance of the electronic device, a user can remove the insertion piece 20 from the electrical connector 12 after the second sealing component 14 is tore off from the first sealing component 13.

In this embodiment, the first sealing component 13 is disposed on the motherboard 11 and located around the periphery of the electrical connector 12, and the second sealing component 14 is disposed on the first sealing component 13 for allowing the second sealing component 14 and the first sealing component 13 to cover the electrical connector 12 on the motherboard 11 and the insertion portion 21 of the insertion piece 20, which not only provides a waterproof effect to a place where the insertion portion 21 of the insertion piece 20 is inserted into the electrical connector 12, but also facilitates the removal of the insertion portion 21 of the insertion piece 20 from the electrical connector 12 on the motherboard 11 during the maintenance of the electronic device.

On the other hand, the second sealing component 14 and the first sealing component 13 has the same shape, which facilitates the second sealing component 14 to be aligned with and adhered on the first sealing component 13. Note that the second sealing component 14 and the first sealing component 13 are not restricted to having the same shape. In some other embodiments, the second sealing component and the first sealing component may have different shapes.

Moreover, the second sealing component 14 is provided with the hollow portion 142 corresponding to the electrical connector 12, and the hollow portion 142 is provided at the light permeable portion 143, which enables the user to observe the connection between the insertion portion 21 of the insertion piece 20 and the electrical connector 12 from the light permeable portion 143, thereby ensuring the insertion portion 21 of the insertion piece 20 to be inserted into the electrical connector 12 accurately.

Note that the hollow portion 142 and the light permeable portion 143 of the second sealing component 14 are optional structures. In some other embodiments, the second sealing component may not include the hollow portion and the light permeable portion; that is, the second sealing component visually blocks the electrical connector. As a result, before the second sealing component is adhered on the first sealing component, the insertion portion of the insertion piece need to be ensured to be accurately inserted into the electrical connector.

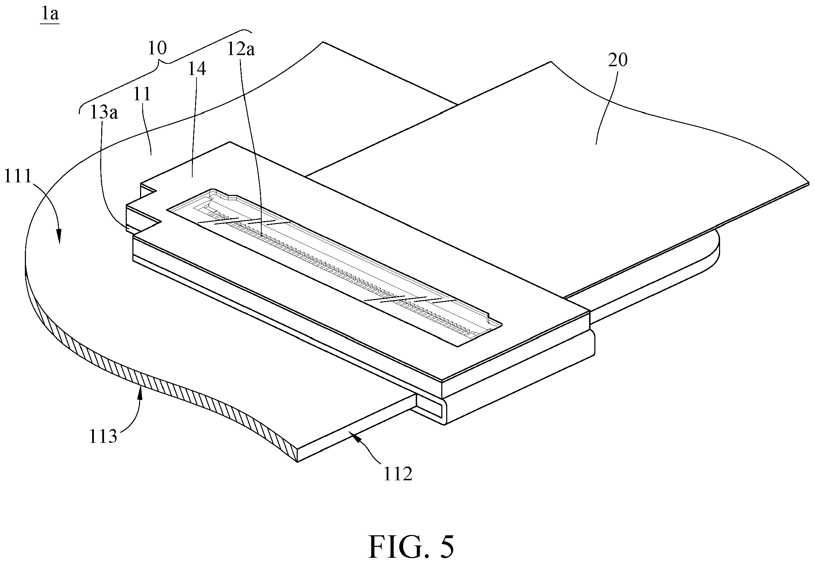

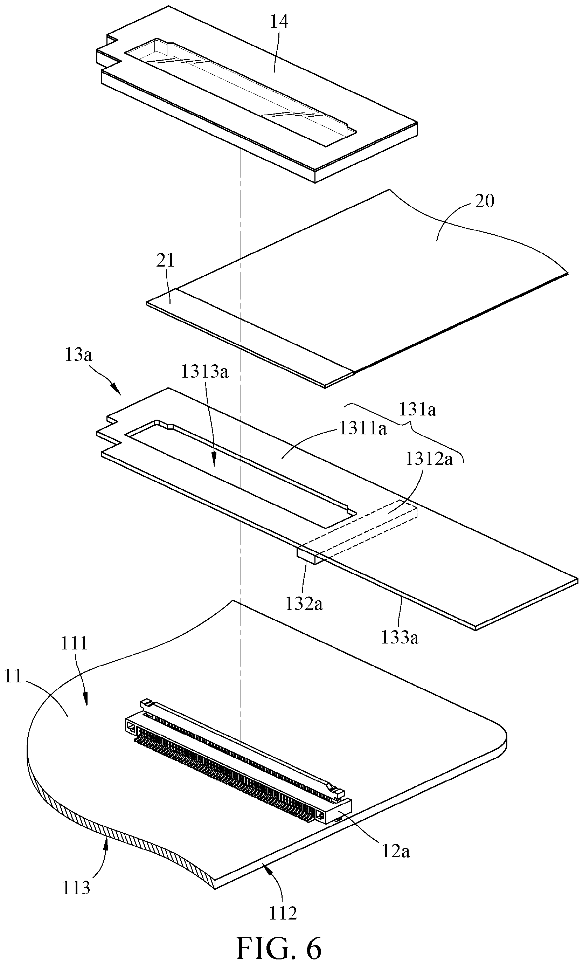

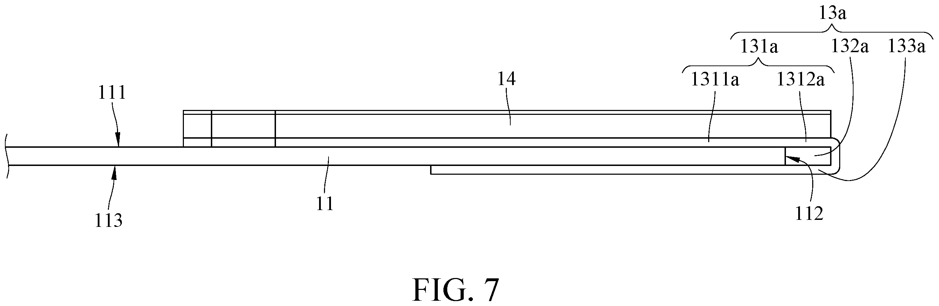

Then, referring to FIGS. 5 to 7, FIG. 5 is a partial perspective view of a motherboard module 1a according to a second embodiment of the invention, FIG. 6 is an exploded view of the motherboard module 1a in FIG. 5, and FIG. 7 is a side view of the motherboard module 1a in FIG. 5.

The motherboard module 1a of this embodiment is similar to the motherboard module 1 of the previous embodiment, and the main differences between them are the position of the electrical connector on the motherboard and the structure of the first sealing component.

In this embodiment, the motherboard module 1a includes a motherboard assembly 10 and an insertion piece 20. The motherboard assembly 10 includes a motherboard 11, an electrical connector 12a, a first sealing component 13a and a second sealing component 14. The motherboard 11 has an upper surface 111, a side surface 112 and a lower surface 113, and the upper surface 111, the side surface 112 and the lower surface 113 face different directions, respectively. The upper surface 111 is connected to the lower surface 113 via the side surface 112, and the lower surface 113 faces away from the upper surface 111. The electrical connector 12a is disposed on the upper surface 111 of the motherboard 11, and one side of the electrical connector 12a is located close to the side surface 112 of the motherboard 11. For example, one side of the electrical connector 12a substantially abuts the side surface 112 of the motherboard 11. In other words, the side of the electrical connector 12a is flush with the side surface 112 of the motherboard 11.

The first sealing component 13a includes an annular portion 131a, a support portion 132a and a reverse folded portion 133a. The annular portion 131a includes a fixed part 1311a and an extension part 1312a connected to each other, and the fixed part 1311a and the extension part 1312a together form an accommodation hole 1313a. Specifically, the accommodation hole 1313a is opened in the annular portion 131a. The fixed part 1311a is fixed on the upper surface 111 of the motherboard 11 via, for example, adhering manner. The extension part 1312a protrudes from the side surface 112 of the motherboard 11. The electrical connector 12a on the motherboard 11 is located in the accommodation hole1313a so as to be surrounded by the fixed part 1311a and the extension part 1312a together. The support portion 132a is fixed to the extension part 1312a, and the reverse folded portion 133a is connected to one side of the extension part 1312a located farther away from the fixed part 1311a. The reverse folded portion 133a is bent along a profile of the support portion 132a and is fixed to the lower surface 113 of the motherboard 11.

The second sealing component 14 is adhered on the fixed part 1311a and the extension part 1312a of the first sealing component 13a. The second sealing component 14 and the fixed part 1311a and the extension part 1312a of the first sealing component 13a together cover the electrical connector 12a and the insertion portion 21 of the insertion piece 20 inserted into the electrical connector 12a.

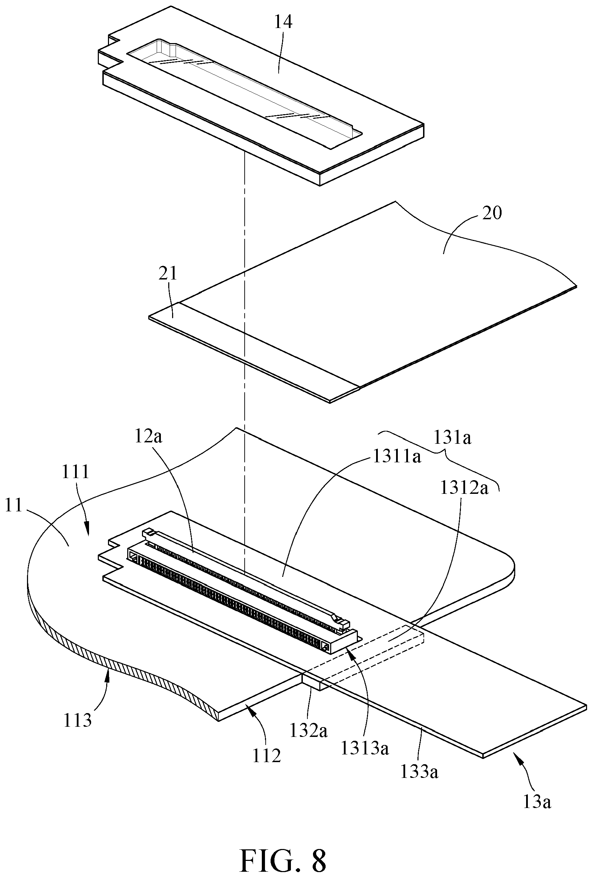

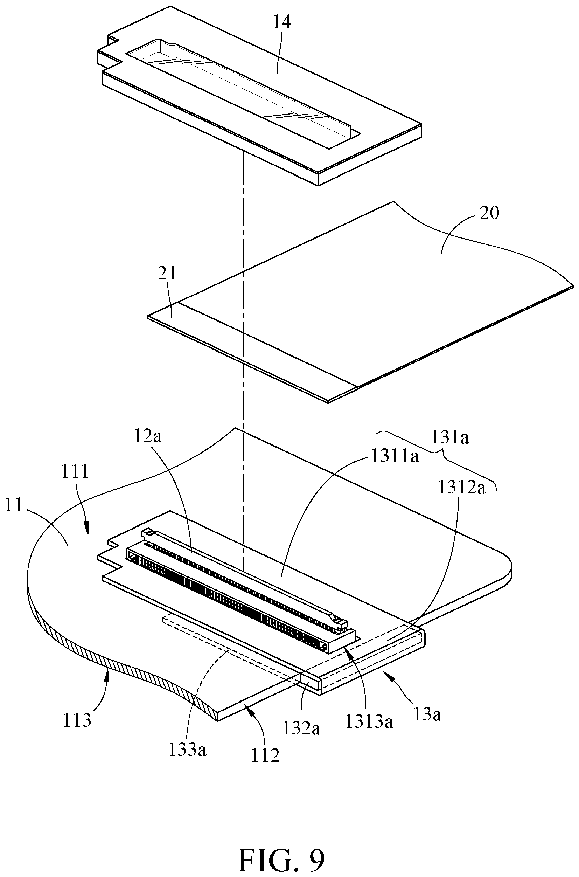

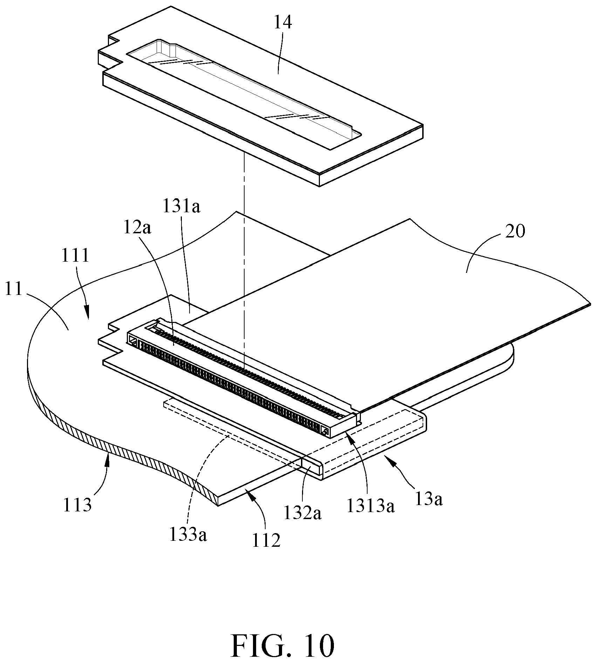

Then, the following descriptions will introduce an assembling method of the motherboard module 1a. Referring to FIGS. 8 to 10, FIGS. 8 to 10 show an assembling process of the motherboard module 1a in FIG. 5. Firstly, as shown in FIG. 8, the fixed part 1311a of the first sealing component 13a is adhered on the uppers surface 111 of the motherboard 11, such that the fixed part 1311a and the extension part 1312a of the first sealing component 13a together surround the periphery of the electrical connector 12a on the motherboard 11. Then, as shown in FIG. 9, the reverse folded portion 133a of the first sealing component 13a is bent along the profile of the support portion 132a and is adhered to the lower surface 113 of the motherboard 11. Then, as shown in FIG. 10, the insertion portion 21 of the insertion piece 20 is inserted into the electrical connector 12a on the motherboard 11. Then, the second sealing component 14 is adhered on the fixed part 1311a and the extension part 1312a of the first sealing component 13a, such that the first sealing component 13a and the second sealing component 14 together cover the electrical connector 12a and the insertion portion 21 of the insertion piece 20 (e.g., as shown in FIG. 5). As a result, the assembly of the motherboard module 1a is finished.

In this embodiment, one side of the electrical connector 12a is located close to the side surface 112 of the motherboard 11, and thus the annular portion 131a of the first sealing component 13a has the extension part 1312a which protrudes from the side surface 112 of the motherboard 11 for the second sealing component 14 to be adhered thereon, which ensures the periphery of the electrical connector 12a is covered by the first sealing component 13a and the second sealing component 14, thereby providing a waterproof effect to a place where the insertion portion 21 of the insertion piece 20 is inserted into the electrical connector 12a on the motherboard 11.

Moreover, after the second sealing component 14 is adhered on the fixed part 1311a and the extension part 1312a of the first sealing component 13a, the support portion 132a of the first sealing component 13a is located at one side of the extension part 1312a located farther away from the second sealing component 14; that is, the support portion 132a of the first sealing component 13a is located below the extension part 1312a for supporting the extension part 1312a and a part of the second sealing component 14.

In addition, the reverse folded portion 133a is bent along the profile of the support portion 132a and is fixed to the lower surface 113 of the motherboard 11, which can further strengthen the effect of supporting the extension part 1312a and a part of the second sealing component 14.

Note that the reverse folded portion 133a of the first sealing component 13 is an optional structure. When the support portion of the first sealing component can sufficiently support the extension part and a part of the second sealing component, the first sealing component may not include the reverse folded portion. Furthermore, the support portion 132a of the first sealing component 13 is an optional structure. When a rigidity of the extension part of the first sealing component is sufficient to support the second sealing component, the first sealing component may not include the extension part.

According to the motherboard modules and the motherboard assemblies as discussed in the above embodiments, the first sealing component is disposed on the motherboard and located around the periphery of the electrical connector, and the second sealing component is disposed on the first sealing component for allowing the second sealing component and the first sealing component to cover the electrical connector on the motherboard and the insertion portion of the insertion piece, which not only provides a waterproof effect to a place where the insertion portion of the insertion piece is inserted into the electrical connector, but also facilitates the removal of the insertion portion of the insertion piece from the electrical connector on the motherboard during the maintenance of the electronic device.

On the other hand, the second sealing component and the first sealing component has the same shape, which facilitates the second sealing component to be aligned with and adhered on the first sealing component.

Moreover, the second sealing component is provided with the hollow portion corresponding to the electrical connector, and the hollow portion is provided at the light permeable portion, which enable the user to observe the connection between the insertion portion of the insertion piece and the electrical connector from the light permeable portion, thereby ensuring the insertion portion of the insertion piece to be inserted into the electrical connector accurately.

It will be apparent to those skilled in the art that various modifications and variations can be made to the present invention. It is intended that the specification and examples be considered as exemplary embodiments only, with a scope of the invention being indicated by the following claims and their equivalents.

## Claims

1. A motherboard module (1, 1a), comprising:
a motherboard assembly (10), comprising:
a motherboard (11);
an electrical connector (12, 12a), disposed on the motherboard (11);
a first sealing component (13, 13a), disposed on the motherboard (11) and located around a periphery of the electrical connector (12, 12a); and
a second sealing component (14), disposed on the first sealing component (13, 13a); and
an insertion piece (20), having an insertion portion (21), wherein the insertion portion (21) is inserted into the electrical connector (12, 12a), and the second sealing component (14) and the first sealing component (13, 13a) cover the electrical connector (12, 12a) and the insertion portion (21) of the insertion piece (20) together.

2. The motherboard module (1, 1a) according to claim 1, wherein the second sealing component (14) comprises an annular portion (141), a hollow portion (142) and a light permeable portion (143), the annular portion (141) is fixed to the first sealing component (13, 13a), the annular portion (141) surrounds the hollow portion (142), the hollow portion (142) corresponds to the electrical connector (12, 12a), and the light permeable portion (143) seals the hollow portion (142).

3. The motherboard module (1a) according to claim 1, wherein the motherboard (11) has an upper surface (111) and a side surface (112), the upper surface (111) and the side surface (112) respectively face different directions, the electrical connector (12a) is disposed on the upper surface (111) of the motherboard (11), one side of the electrical connector (12a) is located close to the side surface (112) of the motherboard (11), the first sealing component (13a) comprises an annular portion (131a), the annular portion (131a) comprises a fixed part (1311a) and an extension part (1312a) connected to each other, the fixed part (1311a) is fixed to the upper surface (111) of the motherboard (11), the extension part (1312a) protrudes from the side surface (112) of the motherboard (11), and the fixed part (1311a) and the extension part (1312a) together surround the electrical connector (12a).

4. The motherboard module (1a) according to claim 3, wherein the side of the electrical connector (12a) abuts the side surface (112) of the motherboard (11).

5. The motherboard module (1a) according to claim 3, wherein the second sealing component (14) is adhered on the fixed part (1311a) and the extension part (1312a) of the annular portion (131a) of the first sealing component (13a).

6. The motherboard module (1a) according to claim 5, wherein the first sealing component (13a) further comprises a support portion (132a), and the support portion (132a) is fixed on the extension part (1312a).

7. The motherboard module (1a) according to claim 6, wherein the motherboard (11) further has a lower surface (113), the lower surface (113) faces away from the upper surface (111), the side surface (112) is connected to the lower surface (113) and the upper surface (111), the first sealing component (13a) further comprises a reverse folded portion (133a), the reverse folded portion (133a) is connected to one side of the extension part (1312a) located farther away from the fixed part (1311a), and the reverse folded portion (133a) is bent along the support portion (132a) and is fixed to the lower surface (113).

8. A motherboard assembly (10), configured for insertion of an insertion piece (20), the motherboard assembly (10) comprising:
a motherboard (11);
an electrical connector (12, 12a), disposed on the motherboard (11) and configured for insertion of an insertion portion (21) of the insertion piece (20);
a first sealing component (13, 13a), disposed on the motherboard (11) and located around a periphery of the electrical connector (12, 12a); and
a second sealing component (14), disposed on the first sealing component (13, 13a), wherein the second sealing component (14) and the first sealing component (13, 13a) are configured to cover the electrical connector (12, 12a) and the insertion portion (21) of the insertion piece (20) together.

9. The motherboard assembly (10) according to claim 8, wherein the second sealing component (14) comprises an annular portion (141), a hollow portion (142) and a light permeable portion (143), the annular portion (141) is fixed to the first sealing component (13, 13a), the annular portion (141) surrounds the hollow portion (142), the hollow portion (142) corresponds to the electrical connector (12, 12a), and the light permeable portion (143) seals the hollow portion (142).

10. The motherboard assembly (10) according to claim 8, wherein the motherboard (11) has an upper surface (111) and a side surface (112), the upper surface (111) and the side surface (112) respectively face different directions, the electrical connector (12a) is disposed on the upper surface (111) of the motherboard (11), one side of the electrical connector (12a) is located close to the side surface (112) of the motherboard (11), the first sealing component (13a) comprises an annular portion (131a), the annular portion (131a) comprises a fixed part (1311a) and an extension part (1312a) connected to each other, the fixed part (1311a) is fixed to the upper surface (111) of the motherboard (11), the extension part (1312a) protrudes from the side surface (112) of the motherboard (11), and the fixed part (1311a) and the extension part (1312a) together surround the electrical connector (12a).

11. The motherboard assembly (10) according to claim 10, wherein the side of the electrical connector (12a) abuts the side surface (112) of the motherboard (11).

12. The motherboard assembly (10) according to claim 10, wherein the second sealing component (14) is adhered on the fixed part (1311a) and the extension part (1312a) of the annular portion (131a) of the first sealing component (13a).

13. The motherboard assembly (10) according to claim 12, wherein the first sealing component (13a) further comprises a support portion (132a), and the support portion (132a) is fixed on the extension part (1312a).

14. The motherboard assembly (10) according to claim 13, wherein the motherboard (11) further has a lower surface (113), the lower surface (113) faces away from the upper surface (111), the side surface (112) is connected to the lower surface (113) and the upper surface (111), the first sealing component (13a) further comprises a reverse folded portion (133a), the reverse folded portion (133a) is connected to one side of the extension part (1312a) located farther away from the fixed part (1311a), and the reverse folded portion (133a) is bent along the support portion (132a) and is fixed to the lower surface (113).

15. An assembling method of a motherboard module (1, 1a), comprising:
assembling a first sealing component (13, 13a) on a motherboard (11) to surround a periphery of an electrical connector (12, 12a) disposed on the motherboard (11);
inserting an insertion portion (21) of an insertion piece (20) into the electrical connector (12, 12a); and
assembling a second sealing component (14) on the first sealing component (13, 13a) to allow the second sealing component (14) and the first sealing component (13, 13a) cover the electrical connector (12, 12a) and the insertion portion (21) of the insertion piece (20) together.
